# EUROPÄISCHE PATENTSCHRIFT

(11) **EP 2 084 618 B1**
(45) Veröffentlichungstag und Bekanntmachung des Hinweises auf die Patenterteilung: **14.08.2019**
(21) Anmeldenummer: 07802187.0
(22) Anmeldetag: 06.09.2007
(51) Int. Cl.: G01R 13/02, G06F 17/18

(54) **VERFAHREN UND VORRICHTUNG ZUR ERMITTLUNG DER HÄUFIGKEITSVERTEILUNG DER IN ÜBERLAPPENDEN BEOBACHTUNGSINTERVALLEN GEMESSENEN SIGNALPEGEL EINES MESSSIGNALS**
METHOD AND DEVICE FOR DETERMINING THE FREQUENCY DISTRIBUTION OF THE SIGNAL LEVELS OF A MEASUREMENT SIGNAL WHICH ARE MEASURED IN OVERLAPPING OBSERVATION INTERVALS
PROCÉDÉ ET DISPOSITIF DE DÉTERMINATION DE LA RÉPARTITION DE FRÉQUENCE DU NIVEAU D'UN SIGNAL DE MESURE MESURÉ DANS DES INTERVALLES D'OBSERVATION SUPERPOSÉS

(30) Priorität: 26.10.2006 DE 102006050616
(43) Veröffentlichungstag der Anmeldung: 05.08.2009
(73) Patentinhaber: Rohde & Schwarz GmbH & Co. KG, 81671 München (DE)
(72) Erfinder: SCHMIDT, Kurt, 85567 Grafing (DE)
(74) Vertreter: Körfer, Thomas
(86) Internationale Anmeldenummer: PCT/EP2007/007791
(87) Internationale Veröffentlichungsnummer: WO 2008/049482

(56) Entgegenhaltungen:
- WO-A-2004/063939
- US-A- 5 448 508
- UNSER M: "Recursion in short-time signal analysis" SIGNAL PROCESSING, Bd. 5, Nr. 3, Mai 1983 (1983-05), Seiten 229-240, XP024231160

## Beschreibung

Die Erfindung betrifft ein Verfahren und eine Vorrichtung zur Ermittlung der Häufigkeitsverteilung der in überlappenden Beobachtungsintervallen jeweils gemessenen Signalpegel eines Mess-Signals.

Eine Vorrichtung zur Aufnahme und Speicherung eines Mess-Signals ist z.B. aus der DE 10 2004 019 967 A1 bekannt. Die Druckschrift M. Unger, "Recursion in short-time signal analysis", Signal Processing, Bd. 5, Nr. 3, Mai 1983, Seiten 229-240, XP024231160, offenbart ein Verfahren zur Ermittlung der Häufigkeitsverteilung von Signalpegeln eines Messsignals in überlappenden Zeitintervallen.

Zyklische Messungen von Signalen im Zeit- oder Frequenzbereich werden entweder in nicht-überlappenden oder in überlappenden Beobachtungsintervallen durchgeführt. Eine Messung in nicht-überlappenden Beobachtungsintervallen weist im Vergleich zu einer Messung in überlappenden Beobachtungsintervallen eine vergleichsweise geringe Korrelation auf, die zu deutlichen Schwankungen der in einem Zeit- oder Frequenzraster gemessenen Signalpegel des Mess-Signals zwischen den einzelnen Beobachtungsintervallen führt. Diese Schwankungen des Signalpegels des Mess-Signals über die einzelnen Beobachtungsintervalle bedingt für den Anwender nachteilig eine unruhige Darstellung des Mess-Signals auf dem Display einer Anzeige-Einrichtung.

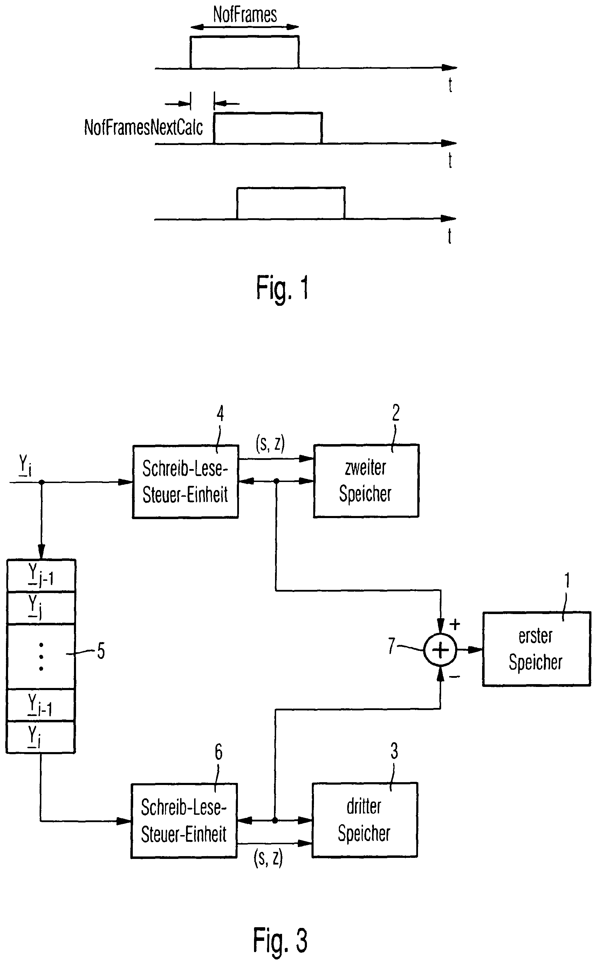

Zur Vermeidung eines derartigen Jitter-Effekts finden in der Messtechnik bevorzugt überlappende Beobachtungsintervalle Anwendung, bei denen jedes Beobachtungsintervall gemäß Fig. 1 aus einer identischen Gesamtanzahl NofFrames von Mess-Zyklen besteht und jeweils zwei aufeinander folgende Beobachtungsintervalle durch eine hierzu geringere Anzahl NofFramesNextCalc von Mess-Zyklen zueinander verzögert sind. Da die Anzahl NofFramesNextCalc von Mess-Zyklen zwischen zwei zueinander verzögerten Beobachtungsintervallen deutlich geringer als die Gesamtanzahl NofFrames von Mess-Zyklen jedes Beobachtungsintervalls ist, ist die Messdatenauswertung quasi-parallel bzw. quasi-gleitend. Somit sind eine Vielzahl von Beobachtungsintervallen - NofFrames/NofFramesNextCalc Beobachtungsintervalle - parallel zu erfassen und auszuwerten, was auch bei heute verfügbarer Rechnerleistung in Echtzeit schwer zu realisieren ist.

Aufgabe der Erfindung ist es deshalb, ein Verfahren und eine Vorrichtung zur quasi gleitenden Erfassung und Auswertung von Signalpegeln eines Mess-Signals in überlappenden Beobachtungsintervallen als echtzeitfähige und rechenzeiteffiziente Lösung zu schaffen.

Die Erfindung wird bezüglich des Verfahrens durch die Merkmale des Anspruchs 1 und bezüglich der Vorrichtung durch die Merkmale des Anspruchs 5 gelöst. Die Unteransprüche enthalten vorteilhafte Weiterbildungen der Erfindung.

Erfindungsgemäß werden anstelle einer quasi-parallelen Erfassung und Auswertung der Signalpegel des Mess-Signals in insgesamt NofFrames/NofFramesNextCalc Beobachtungsintervallen, die jeweils um NofFramesNextCalc Mess-Zyklen zueinander zeitlich verzögert sind, die Signalpegel des Mess-Signals fortlaufend erfasst und hinsichtlich eines vorgegebenen Rasters aus Signalpegelbereichen und Zeit- oder Frequenzwerten ausgewertet und gleichzeitig die um die Anzahl NofFrames von Mess-Zyklen eines Beobachtungsintervalls zeitlich verzögerten Auswertungen der Signalpegel des erfassten Mess-Signals von den unverzögerten Auswertungen der erfassten Signalpegel des Mess-Signals subtrahiert. Das Ergebnis dieser Subtraktion stellt die Anzahl der in einem Beobachtungsintervall in den einzelnen Rasterpunkten liegenden Signalpegel des Mess-Signal dar. Wird diese Subtraktion im Zyklus der in der Verzögerungszeit zwischen zwei zeitlich aufeinander folgenden Beobachtungsintervallen fallenden Anzahl NofFramesNextCalc von Mess-Zyklen durchgeführt, so werden jeweils die in den einzelnen um jeweils NofFramesNextCalc Mess-Zyklen zeitlich zueinander verzögerten Beobachtungsintervallen und in den einzelnen Rasterpunkten erfassten Signalpegel des Mess-Signals ermittelt.

Auf diese Weise reduziert sich die Erfassung der Signalpegel des Mess-Signals von insgesamt NofFrames/NofFramesNextCalc parallel ablaufenden Erfassungen auf eine einzige Erfassung zuzüglich einer zeitlichen Verzögerung. Die Auswertung der Signalpegel des Mess-Signals - Ermittlung der in die einzelnen Signalpegelbereiche und zu den einzelnen Werten des Zeit- oder Frequenzraster jeweils fallenden Anzahl von erfassten Signalpegel des Mess-Signals - reduziert sich von insgesamt NofFrames/NofFramesNextCalc parallel ablaufenden Auswertungen auf die beiden parallel ablaufenden Auswertungen (unverzögerte und verzögerte Auswertung der erfassten Signalpegel des Mess-Signals).

Die erfindungsgemäße Vorrichtung besteht hierzu aus einem ersten Speicher, in dessen Speicherzellen jeweils die Anzahl der in den einzelnen Beobachtungsintervallen im jeweiligen Signalpegelbereich und zum jeweiligen Wert des Zeit- oder Frequenzrasters erfassten Signalpegel des Mess- Signals gespeichert sind, einem zweiten Speicher, in dessen Speicherzellen jeweils die unverzögert im jeweiligen Signalpegelbereich und zum jeweiligen Wert des Zeit- oder Frequenzraster in den einzelnen Mess-Zyklen der einzelnen Beobachtungsintervalle aufaddierte Anzahl von Signalpegeln des Mess-Signals gespeichert sind, und aus einem zweiten Speicher, in dessen Speicherzellen jeweils die verzögert im jeweiligen Signalpegelbereich und zum jeweiligen Wert des Zeit- oder Frequenzraster in den einzelnen Mess-Zyklen der einzelnen Beobachtungsintervallen aufaddierte Anzahl von Signalpegeln des Mess- Signals gespeichert sind.

Zusätzlich enthält die erfindungsgemäße Vorrichtung eine Verzögerungs-Einheit zur Verzögerung der in den einzelnen Signalpegelbereichen und zu den einzelnen Werten des Zeit- oder Frequenzrasters erfassten Signalpegel des Mess-Signals um die Anzahl NofFrames von Mess-Zyklen eines Beobachtungsintervalls und einer Subtrahier-Einheit zur Subtraktion der Speicherinhalte in den einzelnen Speicherzellen des dritten Speichers von den Speicherinhalten in den dazu korrespondierenden Speicherzellen des zweiten Speichers und Speicherung des Subtraktionsergebnisses in den dazu korrespondierenden Speicherzellen des ersten Speichers im Zyklus der Anzahl NofFramesNextCalc von Meß-Zyklen innerhalb der Verzögerungszeit zwischen zwei aufeinander folgenden Beobachtungsintervallen.

Ausführungsbeispiele des erfindungsgemäßen Verfahrens und der erfindungsgemäßen Vorrichtung zur Ermittlung der Häufigkeitsverteilung der in überlappenden Beobachtungsintervallen jeweils gemessenen Signalpegel eines Mess-Signals werden anhand der Zeichnung im Detail erläutert. Die Figuren der Zeichnung zeigen:
- Fig. 1: ein Zeitdiagramm mit überlappenden Beobachtungsintervallen,
- Fig. 2: ein Flussdiagramm eines Ausführungsbeispiels des erfindungsgemäßen Verfahrens zur Ermittlung der Häufigkeitsverteilung der in überlappenden Beobachtungsintervallen jeweils gemessenen Signalpegeln eines Mess-Signals,
- Fig. 3: ein Blockschaltbild eines Ausführungsbeispiels der erfindungsgemäßen Vorrichtung zur Ermittlung der Häufigkeitsverteilung der in überlappenden Beobachtungsintervallen jeweils gemessenen Signalpegel eines Mess-Signals und
- Fig. 4: eine beispielhafte Speicherbelegung des ersten, zweiten und dritten Speichers der erfindungsgemäßen Vorrichtung zur Ermittlung der Häufigkeitsverteilung der in überlappenden Beobachtungsintervallen jeweils gemessenen Signalpegel eines Mess-Signals.

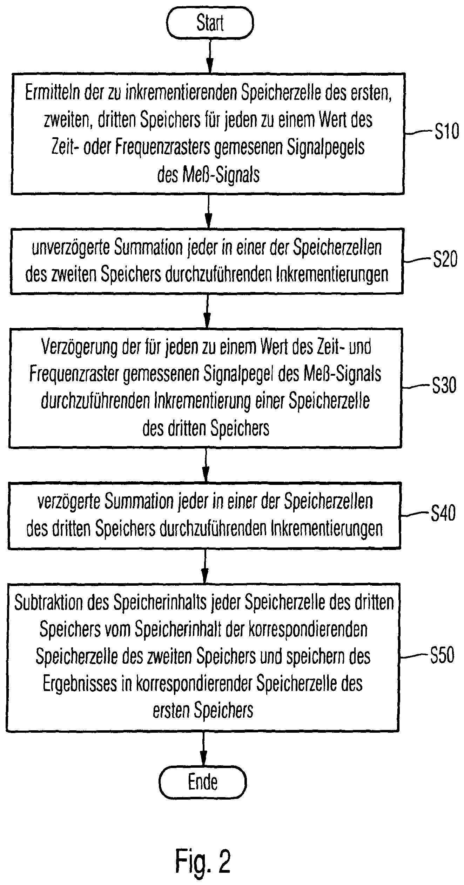

Im folgenden wird das erfindungsgemäße Verfahren zur Ermittlung der Häufigkeitsverteilung der in überlappenden Beobachtungsintervallen jeweils gemessenen Signalpegeln eines Mess-Signals anhand von Fig. 2 beschrieben.

Im ersten Verfahrenschritt S10 wird in jedem Mess-Zyklus der vom Detektor des Messgeräts bzw. -systems zu einem bestimmten Wert des Zeit- oder Frequenzrasters der Messung jeweils gemessene Signalpegel des Mess-Signals in der Auflösung der Pixelgrafik des zum Messgerät bzw. -system gehörigen Displays einer Anzeige-Einrichtung transformiert, in dem die zum Wert des Zeit- oder Frequenzrasters der Messung und zum erfassten Signalpegel des Mess-Signals gehörigen und für einen Mess-Zyklus jeweils zu inkrementierenden Speicherzellen in einer Spalte eines dem Display vorgelagerten und die einzelnen Pixel des Displays ansteuernden ersten Speichers 1 ermittelt werden.

Im nächsten Verfahrensschritt S20 werden in jedem Mess-Zyklus die zu den im vorherigen Verfahrenschritt S10 für eine Inkrementierung ermittelten Speicherzellen des ersten Speichers 1 korrespondierenden Speicherzellen des zweiten Speichers 2 jeweils um den Wert "1" inkrementiert, wobei die durchzuführenden Inkrementierungen der jeweiligen Speicherzellen des zweiten Speichers 2 innerhalb des Intervalls des jeweiligen Messzykluses unverzögert erfolgen.

Der darauf folgende Verfahrensschritt S30 beinhaltet die Verzögerung der im ersten Verfahrenschritt S10 im jeweiligen Mess-Zyklus ermittelten Informationen über im ersten Speicher 1 zu inkrementierende Speicherzellen um eine Verzögerungszeit, die der Anzahl NofFrames von Messzyklen eines Beobachtungsintervalls entspricht.

Mit den in Verfahrenschritt S30 um die Anzahl NofFrames von Mess-Zyklen eines Beobachtungsintervalls verzögerten Informationen über im ersten Speicher zu inkrementierende Speicherzellen werden im darauf folgenden Verfahrenschritt S40 in jedem Mess-Zyklus die dazu korrespondierenden Speicherzellen des dritten Speichers 3 inkrementiert. Die Inkrementierungen der jeweiligen Speicherzellen des dritten Speichers 3 erfolgen dabei gegenüber dem jeweiligen Mess-Zyklus um die Anzahl NofFrames von Mess-Zyklen eines Beobachtungsintervalls verzögert.

Im abschließenden Verfahrenschritt S40 erfolgt im Raster der Anzahl NofFramesNextCalc von Mess-Zyklen, die gemäß Fig. 1 in die Verzögerungszeit zwischen zwei aufeinander folgenden Beobachtungsintervallen fallen, die Subtraktion des Speicherinhalts jeder Speicherzelle des dritten Speichers 3 vom Speicherinhalt der jeweils korrespondierenden Speicherzelle des zweiten Speichers 2 und Speicherung des Ergebnisses der Subtraktion in der korrespondierenden Speicherzelle des ersten Speichers 1.

Im folgenden wird die erfindungsgemäße Vorrichtung zur Ermittlung der Häufigkeitsverteilung der in überlappenden Beobachtungsintervallen jeweils gemessenen Signalpegeln eines Mess-Signals anhand von Fig. 3 beschrieben.

Die im Mess-Zyklus i ermittelten Speicherzellen des ersten Speichers 1, deren Speicherinhalte im Mess-Zyklus i zu inkrementieren sind, werden von einer Funktionseinheit, die in Fig. 3 nicht dargestellt ist, in einer Matrix *Yᵢ* abgelegt und der Schreib-Lese-Steuer-Einheit 4 zur Ansteuerung des zweiten Speichers 2 und der Verzögerungs-Einheit 5 zugeführt.

Die Schreib-Lese-Steuer-Einheit 4 steuert in Abhängigkeit der Inhalte der im Mess-Zyklus i ermittelten Matrix *Yᵢ* die jeweils zu inkrementierenden Speicherzellen des zweiten Speichers 2 über die Adressleitung an, liest den darin abgespeicherten Speicherinhalt der jeweiligen zu inkrementierenden Speicherzelle des zweiten Speichers 2 aus, inkrementiert den ausgelesenen Speicherinhalt um den Wert "1" und speichert den inkrementierten Speicherinhalt wieder in der jeweiligen Speicherzellen des zweiten Speichers 2 ab.

Die Verzögerungs-Einheit 5 verzögert die im Mess-Zyklus i ermittelten Informationen der Matrix *Yᵢ* über die im Mess-Zyklus i zu inkrementierenden Speicherzellen des ersten Speichers 1 um die Anzahl NofFrames von Mess-Zyklen eines Beobachtungsintervalls und gibt diese verzögerten Informationen der Matrix *Yᵢ*, die die in Mess-Zyklus i zu inkrementierenden Speicherzellen des dritten Speichers 3 darstellen, an die Schreib-Lese-Steuer-Einheit 6 zur Ansteuerung des dritten Speichers 3 weiter.

Die Schreib-Lese-Steuer-Einheit 6 steuert in Abhängigkeit der Inhalte der verzögerten Matrix *Yᵢ* die jeweils zu inkrementierenden Speicherzellen des dritten Speichers 3 über die Adressleitung an, liest den darin abgespeicherten Speicherinhalt der jeweiligen zu inkrementierenden Speicherzelle des dritten Speichers 3 aus, inkrementiert den ausgelesenen Speicherinhalt um den Wert "1" und speichert den inkrementierten Speicherinhalt wieder in der jeweiligen Speicherzelle des dritten Speichers 3 ab.

Die Speicherinhalte der Speicherzellen des an die Schreib-Lese-Steuer-Einheit 6 anschließenden dritten Speicher 3 werden von den Speicherinhalten der dazu korrespondierenden Speicherzellen des an die Schreib-Lese-Steuer-Einheit 4 anschließenden zweiten Speichers 2 in der Subtrahier-Einheit 7 jeweils im Zyklus der Anzahl NofFramesNextCalc von Messzyklen, welche in die Verzögerungszeit zwischen zwei aufeinander folgenden Beobachtungsintervallen fallen, subtrahiert und in der korrespondierenden Speicherzelle des an die Subtrahier-Einheit 7 anschließenden ersten Speichers 1 abgespeichert.

Da die in den einzelnen Speicherzellen des ersten, zweiten und dritten Speichers 1, 2 und 3 abgespeicherten Werte inkrementierte Zählerstände über die Häufigkeit der in einem Beobachtungsintervallen erfassten Signalpegel eines Mess-Signals zu den einzelnen Werten des Zeit- oder Frequenzrasters und in den einzelnen Signalpegelbereichen darstellen, ist die Wortbreite der einzelnen Speicherzellen an die maximal innerhalb eines Beobachtungsintervalls zu erwartende Häufigkeit des Auftretens von zu den einzelnen Werten des Zeit- oder Frequenzrasters gehörigen Signalpegeln des Mess-Signals innerhalb der einzelnen Signalpegelbereiche auszulegen. Da innerhalb eines Beobachtungsintervalls ein zu einem bestimmten Wert des Zeit- oder Frequenzrasters gehöriger Signalpegel des Mess-Signals maximal NofFrames-mal innerhalb eines Signalpegelbereichs auftreten kann, ist die Wortbreite jeder Speicherzelle des ersten, zweiten und dritten Speichers 1, 2 und 3 auf ld(NofFrames+1) zu begrenzen.

Die Verzögerung der Informationen der Matrix *Yᵢ* über die im Mess-Zyklus i zu inkrementierenden Speicherzellen des ersten Speichers 1 kann alternativ zur Verzögerungs-Einheit 5 im dritten Speicher 3 durchgeführt werden. Hierzu führt die Schreib-Lese-Steuer-Einheit 6 die im Mess-Zyklus i entsprechend der Inhalte der Matrix *Yᵢ* in den einzelnen Speicherzellen des dritten Speichers 3 durchzuführenden Inkrementierungen verzögert um die in ein Beobachtungsintervall fallende Anzahl NofFrames von Mess-Zyklen durch.

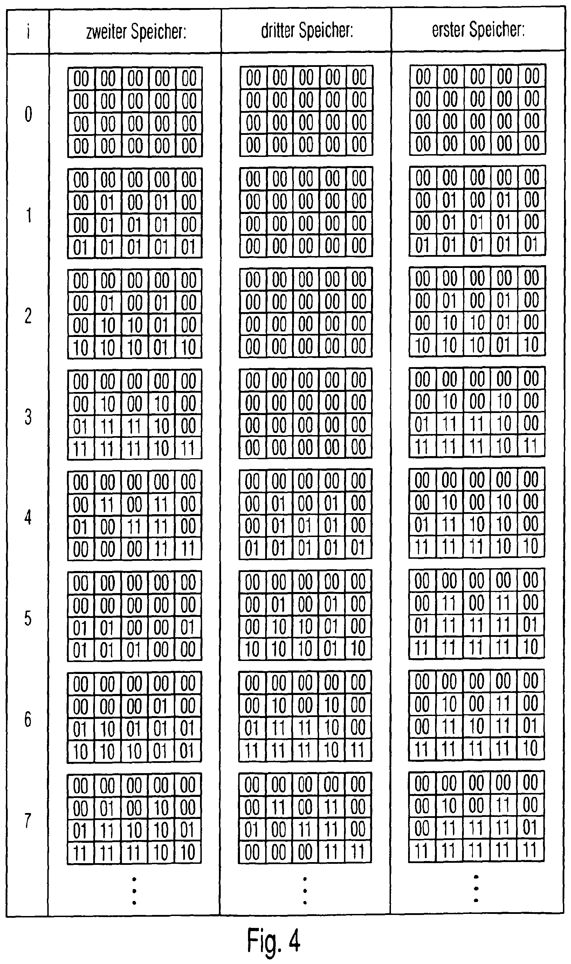

In Fig. 4 ist eine beispielhafte Speicherbelegung der Speicherzellen des ersten, zweiten und dritten Speichers 1, 2 und 3 mit NofFrames=3 und NofFramesNextCalc=1 für mehrere zeitlich aufeinander folgende Mess-Zyklen i bei einer Wortbreite der Speicherzellen von 2 dargestellt:
In den Speicherzellen des zweiten Speichers sind die in den einzelnen Mess-Zyklen i durchgeführten Inkrementierungen zu erkennen, die aufgrund der zu den einzelnen Messpunkten des Zeit- oder Frequenzrasters unterschiedlich hohen Signalpegeln des Mess-Signals von Mess-Zyklus zu Mess-Zyklus schwanken.

In den Speicherzellen des dritten Speichers sind die um insgesamt drei Mess-Zyklen gegenüber den Inkrementierungen der Speicherzellen des zweiten Speichers verzögerten Inkrementierungen ersichtlich.

Wie leicht nachzuvollziehen ist, enthalten de Speicherzellen des ersten Speichers jeweils die in den jeweils letzten drei Mess-Zyklen in Summe ermittelte Anzahl von Inkrementierungen des zweiten Speichers (d.h. erster Speicher (i=4) = zweiter Speicher (i=1) + zweiter Speicher (i=2) + zweiter Speicher (i=3); erster Speicher (i=5) = zweiter Speicher (i=2) + zweiter Speicher (i=3) + zweiter Speicher (i=3); erster Speicher (i=6) = zweiter Speicher (i=3) + zweiter Speicher (i=4) + zweiter Speicher (i=5) usw.).

Zu erkennen ist auch, dass das erfindungsgemäße Verfahren und die erfindungsgemäße Vorrichtung eine Einschwingzeit über die ersten drei Mess-Zyklen - i = 0, 1, 2 - benötigt, bis korrekte Werte über die in einem Beobachtungsintervall über insgesamt drei Mess-Zyklen ermittelte Anzahl von Signalpegeln des Mess-Signals innerhalb der einzelnen Signalpegelbereiche und zu den einzelnen Werten des Zeit- oder Frequenzrasters vorliegen.

Die Erfindung ist nicht auf die dargestellte Ausführungsform des erfindungsgemäßen Verfahrens und der erfindungsgemäßen Vorrichtung zur Ermittlung der Häufigkeitsverteilung der in überlappenden Beobachtungsintervallen jeweils gemessenen Signalpegel eines Mess-Signals beschränkt. Von der Erfindung sind insbesondere auch zusätzlich integrierte Verfahren und Vorrichtungen zur Minimierung der Anzahl durchzuführender Inkrementierungen in den einzelnen Speichern bei einer Folge von in einer Zeile oder einer Spalte der Speicher zu inkrementierenden Speicherzellen abgedeckt.

## Patentansprüche

1. Verfahren zum Ermitteln der Häufigkeitsverteilung des in überlappenden Beobachtungsintervallen über ein Zeit- oder Frequenzraster jeweils gemessenen Signalpegels eines Mess-Signals mit folgenden Verfahrensschritten:
Ermitteln der für einen gemessenen Signalpegel des Mess-Signals bei einem Wert des Zeit- oder Frequenzrasters jeweils durchzuführenden Inkrementierung einer Speicherzelle in einem ersten Speicher (1),
das Verfahren ist
**gekennzeichnet durch**
unverzögertes Summieren der für jede Speicherzelle des ersten Speichers (1) in jedem Mess-Zyklus jeweils ermittelten Inkrementierung und Speichern des Ergebnisses des unverzögerten Summierens in einem zweiten Speicher (2),
verzögertes Summieren der für jede Speicherzelle des ersten Speichers (1) in jedem Mess-Zyklus jeweils ermittelten Inkrementierung und Speichern des Ergebnisses des verzögerten Summierens in einem dritten Speicher (3) und
Subtrahieren des Ergebnisses des verzögerten Summierens der für jede Speicherzelle des ersten Speichers (1) in jedem Mess-Zyklus jeweils ermittelten Inkrementierung vom Ergebnis des unverzögerten Summierens der für jede Speicherzelle des ersten Speichers (1) in jedem Mess-Zyklus jeweils ermittelten Inkrementierung.

2. Verfahren zum Ermitteln der Häufigkeitsverteilung nach Anspruch 1,
**dadurch gekennzeichnet,**
**dass** das verzögerte Summieren gegenüber dem unverzögerten Summieren um eine bestimmte Anzahl (NofFrames) von Mess-Zyklen des Beobachtungsintervalls verzögert durchgeführt wird.

3. Verfahren zum Ermitteln der Häufigkeitsverteilung nach Anspruch 1 oder 2,
**dadurch gekennzeichnet,**
**dass** zum Subtrahieren des Ergebnisses des verzögerten Summierens vom Ergebnis des unverzögerten Summierens der Speicherinhalt jeder Speicherzelle des dritten Speichers (3) vom Speicherinhalt der dazu korrespondierenden Speicherzelle des zweiten Speichers (2) subtrahiert wird und in der korrespondierenden Speicherzelle eines ersten Speichers (4) abgespeichert wird.

4. Verfahren zum Ermitteln der Häufigkeitsverteilung nach Anspruch 3,
**dadurch gekennzeichnet,**
**dass** das Subtrahieren des Ergebnisses des verzögerten Summierens vom Ergebnis des unverzögerten Summierens im Zyklus einer bestimmten Anzahl (NofFramesNextCalc) von Mess-Zyklen erfolgt, die in die Verzögerungszeit zwischen zwei aufeinander folgenden Beobachtungsintervallen fallen.

5. Vorrichtung zum Ermitteln der Häufigkeitsverteilung des in überlappenden Beobachtungsintervallen über ein Zeit- oder Frequenzraster jeweils gemessenen Signalpegels eines Mess-Signals, wobei die Vorrichtung
**dadurch gekennzeichnet ist,**
**dass** sie ausgerüstet ist
mit einem ersten, zweiten und dritten Speicher (1, 2, 3), in deren einzelnen Speicherzellen jeweils die in Messzyklen des Beobachtungsintervalls jeweils inkrementierte Anzahl von in zugehörigen Signalpegelbereichen und zu zugehörigen Werten des Zeit- oder Frequenzrasters gemessenen Signalpegeln des Mess-Signals enthalten sind, wobei in den Speicherzellen des zweiten Speichers (2) jeweils eine unverzögerte Anzahl gemessener Signalpegel des Mess-Signals, in den Speicherzellen des dritten Speichers (3) jeweils eine verzögerte Anzahl gemessener Signalpegel des Mess-Signals und in den Speicherzellen des ersten Speichers (1) die Differenz zwischen unverzögerter und verzögerter Anzahl gemessener Signalpegel enthalten sind,
mit einer dem dritten Speicher (3) vorgeschalteten Verzögerungs-Einheit (5) zur Verzögerung der unverzögerten Anzahl von gemessenen Signalpegeln des Mess-Signals und mit einer dem zweiten und dritten Speicher (2, 3) nachgeschalteten und dem ersten Speicher (1) vorgeschalteten Subtrahier-Einheit (7) zur Subtraktion der verzögerten Anzahl gemessener Signalpegel von der unverzögerten Anzahl gemessener Signalpegel.

6. Vorrichtung zum Ermitteln der Häufigkeitsverteilung nach Anspruch 5,
**dadurch gekennzeichnet,**
**dass** dem zweiten Speicher (2) und dritten Speicher (3) jeweils eine Schreib-Lese-Steuer-Einheit (4, 6) zur Steuerung der Inkrementierung der Speicherzellen des zweiten Speichers (2) und des dritten Speichers (3) vorgeschaltet ist.

## Claims

1. Method for determining the frequency distribution of the signal level of a measurement signal which is respectively measured in overlapping observation intervals by means of a time or frequency raster with the following method steps:
determination of the incrementation of a memory cell in a first memory (1) to be carried out for a measured signal level of the measurement signal at a value of the time or frequency raster, the method being
**characterised by**
undelayed summation of the incrementation respectively determined for each memory cell of the first memory (1) in each measurement cycle and buffering of the result of the undelayed summation in a second memory (2),
delayed summation of the incrementation respectively determined for each memory cell of the first memory (1) in each measurement cycle and buffering of the result of the delayed summation in a third memory (3) and
subtraction of the result of the delayed summation of the incrementation respectively determined for each memory cell of the first memory (1) in each measurement cycle from the result of the undelayed summation of the incrementation respectively determined for each memory cell of the first memory (1) in each measurement cycle.

2. Method for determining the frequency distribution according to claim 1,
**characterised in that**
the delayed summation is carried out delayed by a particular number (NofFrames) of measurement cycles of the observation interval in relation to the undelayed summation.

3. Method for determining the frequency distribution according to one of claims 1 or 2,
**characterised in that**
for subtraction of the result of the delayed summation from the result of the undelayed summation, the memory content of each memory cell of the third memory (3) is subtracted from the memory content of the corresponding memory cell of the second memory (2) and buffered in the corresponding memory cell of a first memory (4).

4. Method for determining the frequency distribution according to claim 3,
**characterised in that**
the subtraction of the result of the delayed summation from the result of the undelayed summation is carried out in the cycle of a particular number (NofFramesNextCalc) of measurement cycles which fall in the delay time between two successive observation intervals.

5. Device for determining the frequency distribution of the signal level of a measurement signal which is respectively measured in overlapping observation intervals by means of a time or frequency raster, the device being
**characterised in that**
it is equipped
with a first, second and third memory (1, 2, 3) the individual memory cells of which respectively contain the number of signal levels of the measurement signal respectively incremented in measurement cycles of the observation interval measured in associated signal level ranges and at associated values of the time or frequency raster,
wherein the memory cells of the second memory (2) respectively contain an undelayed number of measured signal levels of the measurement signal, the memory cells of the third memory (3) respectively contain a delayed number of measured signal levels of the measurement signal and the memory cells of the first memory (1) respectively contain the difference between the undelayed and delayed number of measured signal levels,
with a delay unit (5) connected upstream of the third memory (3) for delaying the undelayed number of measured signal levels of the measurement signal and
with a subtraction unit (7) connected downstream of the second and third memories (2, 3) and upstream of the first memory (1) for substracting the delayed number of measured signal levels from the undelayed number of measured signal levels.

6. Device for determining the frequency distribution according to claim 5,
**characterised in that**
connected upstream of the second memory (2) and the third memory (3) there is respectively a write-read-control unit (4, 6) for controlling the incrementation of the memory cells of the second memory (2) and the third memory (3).

## Revendications

1. Procédé pour déterminer la distribution des fréquences du niveau, mesuré respectivement par intervalles d'observation se chevauchant sur toute l'étendue d'une grille de temps ou de fréquences, d'un signal de mesure, le procédé comprenant les étapes suivantes :
la détermination de l'incrémentation, à réaliser respectivement pour un niveau mesuré du signal de mesure pour une valeur de la grille de temps ou de fréquences, d'une cellule de mémoire dans une première mémoire (1), le procédé est **caractérisé par**
l'addition non retardée de l'incrémentation déterminée respectivement au cours de chaque cycle de mesure pour chaque cellule de mémoire de la première mémoire (1) et la mise en mémoire du résultat de l'addition non retardée dans une deuxième mémoire (2),
l'addition retardée de l'incrémentation déterminée respectivement au cours de chaque cycle de mesure pour chaque cellule de mémoire de la première mémoire (1) et la mise en mémoire du résultat de l'addition retardée dans une troisième mémoire (3) et
la soustraction du résultat de l'addition retardée de l'incrémentation déterminée respectivement au cours de chaque cycle de mesure pour chaque cellule de mémoire de la première mémoire (1) du résultat de l'addition non retardée de l'incrémentation déterminée respectivement au cours de chaque cycle de mesure pour chaque cellule de mémoire de la première mémoire (1).

2. Procédé pour déterminer la distribution de fréquences selon la revendication 1,
**caractérisé**
**en ce que** l'addition retardée est réalisée avec retard, par rapport à l'addition non retardée, d'un nombre défini (NofFrames) de cycles de mesure de l'intervalle d'observation.

3. Procédé pour déterminer la distribution des fréquences selon la revendication 1 ou 2,
**caractérisé**
**en ce que**, pour soustraire le résultat de l'addition retardée du résultat de l'addition non retardée, le contenu de mémoire de chaque cellule de mémoire de la troisième mémoire (3) est soustrait du contenu de mémoire de la cellule de mémoire correspondante à celle de la deuxième mémoire (2) et mis en mémoire dans la cellule de mémoire correspondante d'une première mémoire (4).

4. Procédé pour déterminer la distribution des fréquences selon la revendication 3,
**caractérisé**
**en ce que** la soustraction du résultat de l'addition retardée du résultat de l'addition non retardée s'effectue au cours d'un cycle d'un nombre défini (NofFramesNextCalc) de cycles de mesure, qui tombent pendant le temps de retard entre deux intervalles d'observation successifs.

5. Dispositif pour déterminer la distribution des fréquences du niveau, mesuré respectivement par intervalles d'observation se chevauchant sur toute l'étendue d'une grille de temps ou de fréquences, d'un signal de mesure, dans lequel le dispositif est **caractérisé en ce qu'**il est équipé
d'une première, d'une deuxième et d'une troisième mémoire (1, 2, 3), dans les cellules de mémoire individuelles desquelles sont contenus respectivement le nombre, respectivement incrémenté au cours de cycles de mesure de l'intervalle d'observation, de niveaux mesurés du signal de mesure dans des plages de niveaux de signal associés et pour des valeurs associées de la grille de temps ou de fréquences, dans lequel respectivement un nombre non retardé de niveaux mesurés du signal de mesure sont contenus dans les cellules de mémoire de la deuxième mémoire (2), respectivement un nombre retardé de niveaux mesurés du signal de mesure sont contenus dans les cellules de mémoire de la troisième mémoire (3) et la différence entre le nombre non retardé et le nombre retardé de niveaux mesurés est contenue dans les cellules de mémoire de la première mémoire (1),
d'une unité de retard (5) montée en amont de la troisième mémoire (3) et destinée à retarder le nombre non retardé de niveaux mesurés du signal de mesure et
d'une unité de soustraction (7) montée en aval de la deuxième et de la troisième mémoire (2, 3) et montée en amont de la première mémoire (1), destinée à soustraire le nombre retardé de niveaux mesurés du signal du nombre non retardé de niveaux mesurés du signal.

6. Dispositif pour déterminer la distribution des fréquences selon la revendication 5,
**caractérisé**
**en ce que** respectivement une unité d'écriture-de lecturede commande (4, 6) destinée à commander l'incrémentation des cellules de mémoire de la deuxième mémoire (2) et de la troisième mémoire (3) est montée en amont de la deuxième mémoire (2) et de la troisième mémoire (3).
